# EUROPEAN PATENT APPLICATION

(11) **EP 2 178 132 A1**
(43) Date of publication of application: **21.04.2010**
(21) Application number: 08792059.1
(22) Date of filing: 01.08.2008
(51) Int. Cl.: H01L 51/50, H05B 33/10

(54) **ORGANIC ELECTROLUMINESCENT DEVICE, METHOD FOR MANUFACTURING THE SAME, AND COATING LIQUID**

(30) Priority: 10.08.2007 JP 2007210451
(71) Applicant: Sumitomo Chemical Company, Limited, Tokyo 104-8260 (JP)
(72) Inventor: MORISHIMA, Shinichi, Tsukuba-shi Ibaraki 305-0047 (JP)
(74) Representative: Jackson, Martin Peter
(86) International application number: PCT/JP2008/063846
(87) International publication number: WO 2009/022555

(57) **Abstract**

It is an object of the present invention to provide an organic EL element that can be easily manufactured and has a good light-emitting property and lifetime property, a method for manufacturing the same and materials used for manufacturing the same.

The organic EL element having an anode, a light-emitting layer, a cathode, and a metal oxide layer provided between the anode and the light-emitting layer or between the light-emitting layer and the cathode, wherein the metal oxide layer is a layer obtained by applying a solution containing metal oxide and a solvent on an other layer that composes the element, as well as a method for manufacturing the same and a coating solution used for manufacturing the same are provided.

## Description

### TECHNICAL FIELD

The present invention relates to an organic electroluminescence element (hereinafter, may be referred to as an organic EL element), a method for manufacturing the same and a coating solution used for manufacturing the same.

### BACKGROUND ART

Organic EL elements have various advantages that they can be driven by lower voltage, have a higher luminance and easily emit multiple colored lights compared with an inorganic EL element. Thus, conventionally the organic EL elements have been studied in various respects to obtain the elements having superior properties. In particular, many attempts for materials of respective layers that constitute the element have been reported.

In particular, it has been studied to use a metal oxide as a layer such as an electron injection layer and a hole injection layer. For example, Patent Document 1 describes that an inorganic oxide layer of molybdenum oxide is provided as a highly efficient electron injection layer on an electron injection electrode.

Such a metal oxide layer is generally made by a process that requires an atmosphere with a high vacuum degree, such as a vacuum deposition, but there are problems that expensive manufacturing equipments and complicated manipulations are required for carrying out such a process. Thus, it is required to develop a method for making the inorganic oxide layer, which can be carried out more conveniently than the conventional method such as the vacuum deposition, and obtains the metal oxide that exerts effects such as enhancement of the luminance and prolongation of light emission life that are equal to or more excellent than those in the metal oxide produced by the conventional method.

Patent Document 1: JP 2002-367784-A

### DISCLOSURE OF INVENTION

### PROBLEM TO BE SOLVED BY THE INVENTION

It is an object of the present invention to provide an organic EL element that can be easily manufactured and has a good light-emitting property and lifetime property, a method for manufacturing the same and materials used for manufacturing the same.

### MEANS FOR SOLVING PROBLEM

As a result of an extensive study in the light of such a circumstance, the present inventors surprisingly have found that it is possible to easily prepare a metal oxide layer capable of enhancing a light-emitting property and a lifetime property of an organic EL element by applying a metal oxide as a solution, and completed the present invention.

Accordingly, the present invention provides the followings:
[1] An organic electroluminescence element comprising an anode, a light-emitting layer, a cathode, and a metal oxide layer provided between said anode and said light-emitting layer or between the light-emitting layer and the cathode,
   wherein the metal oxide layer is a layer formed by applying a solution containing metal oxide and a solvent on another layer that constitutes the element.
[2] The organic electroluminescence element according to the above [1], wherein the metal oxide layer is a hole injection layer, or is provided in direct contact with the light-emitting layer or the hole injection layer.
[3] The organic electroluminescence element according to the above [1] or [2], wherein a visible light transmittance of the metal oxide layer is 50% or more.
[4] The organic electroluminescence element according to any one of the above [1] to [3], wherein the metal oxide is selected from the group consisting of molybdenum oxide, vanadium oxide, tungsten oxide and mixtures thereof.
[5] A method for manufacturing the organic electroluminescence element according to any one of the above [1] to [4], comprising a step of applying the solution on the another layer that constitutes the element.
[6] The manufacturing method according to the above [5], wherein the applying is performed by a spin coating method, a cast method, a capillary coating method or a printing method.
[7] A coating solution comprising metal oxide and a solvent, being used for making a metal oxide layer in the organic electroluminescence element according to the above [1].

### EFFECT OF THE INVENTION

The organic EL element of the present invention can be easily manufactured and has the good light-emitting property and lifetime property because the inorganic oxide layer can be provided easily with high quality. Therefore, the organic EL element of the present invention can be preferably used for planar light sources as backlights and devices such as flat panel displays.

### BEST MODES FOR CARRYING OUT THE INVENTION

The organic EL element of the present invention has an anode, a light-emitting layer and a cathode. The organic EL element of the present invention can further have other layers between the anode and the light-emitting layer and/or between the light-emitting layer and the cathode, but has a metal oxide layer as an essential component, which is at least one layer among those layers.

The metal oxide that constitutes the metal oxide layer may preferably include molybdenum oxide, vanadium oxide, tungsten oxide and mixtures thereof. Molybdenum oxide is particularly preferable among them. Molybdenum trioxide, i.e., MoO₃, is preferable as molybdenum oxide. Divanadium pentaoxide, i.e., V₂O₅, is preferable as vanadium oxide. Tungsten trioxide, i.e., WO₃, is preferable as tungsten oxide. When a film of MoO₃ is formed by steps defined in the present invention, a composition ratio of Mo and O in the formed metal oxide layer can not be kept in some cases, but in those cases, the metal oxide can be used preferably in the present invention. Types of the metal oxide that constitutes the metal oxide layer may be one or two or more.
The metal oxide layer includes metal oxide such as the above metal oxide, and preferably is substantially composed of metal oxide such as the above metal oxide. More specifically, when a monolayer of the metal oxide layer is formed, a rate occupied by the metal oxide in an entire amount of substances that compose the layer can be preferably 98% by weight or more, more preferably 99% by weight or more and further more preferably 99.9% by weight or more.

The metal oxide layer is preferably a hole injection layer, or is provided in direct contact with the light-emitting layer or the hole injection layer. More specifically, it is preferable that the metal oxide layer is any of the followings:
(i) it is provided in contact with the anode and a hole transport layer;
(ii) it is provided in contact with the anode and an electron block layer;
(iii) it is provided in contact with the hole injection layer and the light-emitting layer;
(iv) it is provided in contact with the hole injection layer and the electron block layer; or
(v) it is provided in contact with the anode and the light-emitting layer.
In the case of a bottom emission structure, (i) or (ii) is preferable and the metal oxide layer ordinarily works as the hole injection layer. In the case of a top emission structure, (iii) or (iv) is preferable and the metal oxide layer ordinarily works as the hole transport layer.

A visible light transmittance of the metal oxide layer is preferably 50% or more and 100% or less. By having the visible light transmittance of 50% or more and 100% or less, it is possible to suitably use the metal oxide layer for the type of the organic EL element which emits light going through the metal oxide layer. The visible light transmittance is more preferably 70% or more and 100% or less. By having the visible light transmittance of 70% or more and 100% or less, the light is extracted from a deeper part of the light-emitting layer and a light-emitting efficiency of the organic EL element is enhanced.

A thickness of the metal oxide layer is not particularly limited, but is preferably 10 to 50 nm.

In the organic EL element of the present invention, the metal oxide layer is the layer formed by applying a solution containing the metal oxide and a solvent on the other layer that constitutes the element.
As the solvent, water, an organic solvent and a mixture thereof may be used, the water is preferable, and ultrapure water is particularly preferable. The ultrapure water is the water having an electric conductivity of 0.06 µS·cm or less at a water temperature of 25°C. The solvent is a mixture of the water and the organic solvent. The organic solvent may also be the solvent containing alcohol such as methanol, ethanol, acetone, isopropyl alcohol, 2-ethoxyethanol and 2-butoxyethanol.

A concentration of the metal oxide in the solution is not particularly limited, and can be from 0.01% by weight to a saturation concentration at an application temperature, and in particular is preferably the saturation concentration at the application temperature. Specifically, a saturated solution can be obtained by, for example, adding metal oxide in the amount equal to or more than a saturated amount into the solvent and scooping out supernatant or removing precipitate by filtration.

The solution may further contain other ingredients in addition to the metal oxide and the solvent. Specifically, the solution may contain a low molecular organic compound and a high molecular organic compound.

Usable examples for applying the solution may include coating methods such as a spin coating method, a casting method (cast method), a microgravure coating method, a gravure coating method, a bar coating method, a roll coating method, a wire bar coating method, a dip coating method, a slit coating method, a capillary coating method, a spray coating method and a nozzle coating method; and printing methods such as a gravure printing method, a screen printing method, a flexographic printing method, an offset printing method, a reverse printing method and an inkjet printing method. Among them, the spin coating method, the cast method, the capillary coating method and the printing methods are preferable. The printing methods such as the gravure printing method, the screen printing method, the flexographic printing method, the offset printing method, the reverse printing method and the inkjet printing method are more preferable because patterning is easy. The "other layer that constitutes the element", which is subjected to the application, may be any layer that constitutes the organic EL element, and may be appropriately selected depending on manufacturing steps and a laminated structure of the resulting organic EL element. For example, the application may be conducted on the layer of the anode or the cathode provided on the substrate, thus obtaining the metal oxide layer in direct contact with the electrode. Alternatively, the electrode is provided on the substrate, and subsequently one or more other layers such as the light-emitting layer, a charge injection layer, a charge transport layer or a charge block layer are provided on the electrode, and then, the application may be further conducted thereon, thus obtaining the metal oxide layer in direct contact the layer.

After conducting the application, the metal oxide layer can be obtained through steps such as volatilizing the solvent via natural drying and curing the layer if necessary. The curing can be conducted by a treatment with heat. Specifically, the treatment with heat can be conducted, for example, at 80 to 150°C for 1 to 20 minutes.

The laminated metal oxide layer can be subjected to a step of further laminating the other layer that composes the element directly or optionally after being subjected to other steps such as the treatment with UV-O₃, the treatment with heat performed after being cured and exposure to atmospheric air, thus completing the organic EL element.

The treatment with UV-O₃ may be performed by irradiating with ultraviolet light at an intensity of 1 to 100 mW/cm² for 5 seconds to 30 minutes and treating under an atmosphere of ozone at a concentration of 0.001 to 99%. The treatment with heat performed after being cured may be performed under a condition at 50 to 350°C for 1 to 120 minutes. The exposure to the atmospheric air may be performed by leaving stand in the atmospheric air at a humidity of 40 to 95% and temperature of 20 to 50°C for 1 to 20 days.

Subsequently, the configuration of the layer of the organic EL element of the present invention will be explained more specifically.

The organic EL element of the present invention essentially has the anode, the light-emitting layer and the cathode, and, in addition, may have the other additional layers between the anode and the light-emitting layer and/or between the light-emitting layer and the cathode.

Examples of the layer that may be provided between the anode and the light-emitting layer may include the electron injection layer, an electron transport layer, and a hole block layer. When both the electron injection layer and the electron transport layer are provided, the layer close to the cathode is the electron injection layer, and the layer close to the light-emitting layer is the electron transport layer.

The electron injection layer is the layer having the function of improving an electron injection efficiency from the cathode, and the electron transport layer is the layer having the function of improving an electron transport from the cathode, the electron injection layer and the electron transport layer closer to the cathode, to the light-emitting layer. When the electron injection layer or the electron transport layer has the function of blocking the transport of holes, these layers may also serve as the hole block layer.
For having the function of blocking the transport of holes, the blocking effect can be confirmed by, for example, making an element that runs a hole current alone and observing the reduction of its current value.

Examples of those provided between the anode and the light-emitting layer may include the hole injection layer, a hole transport layer and an electron block layer. When both the hole injection layer and the hole transport layer are provided, the layer close to the anode is the hole injection layer and the layer close to the light-emitting layer is the hole transport layer.

The hole injection layer is the layer having the function of improving a hole injection efficiency from the anode, and the hole transport layer is the layer having the function of improving a hole transport from the anode, the hole injection layer and the hole transport layer closer to the anode, to the light-emitting layer. When the hole injection layer or the hole transport layer has the function of blocking the transport of electrons, these layers may also serve as the electron block layer.
For having the function of blocking the transport of electrons, the blocking effect can be confirmed by, for example, making an element that runs an electron current alone and observing the reduction of its current value.

In the organic EL element of the present invention, one layer of the light-emitting layer is ordinarily provided, but two or more layers of the light-emitting layers can be provided without being limited to the one layer. In that case, two or more layers of the light-emitting layer can be stacked in direct contact with each other, or the metal oxide layer used for the present invention can be provided between such layers.

The electron injection layer and the hole injection layer may be collectively referred to as the charge injection layer in some cases. The electron transport layer and the hole transport layer may be collectively referred to as the charge transport layer in some cases.

More specifically, the organic EL element of the present invention can have any of the following layered configurations:
a) anode/hole transport layer/light-emitting layer/cathode;
b) anode/light-emitting layer/electron transport layer/cathode;
c) anode/hole transport layer/light-emitting layer/electron transport layer/cathode;
d) anode/charge injection layer/light-emitting layer/cathode
e) anode/light-emitting layer/charge injection layer/cathode;
f) anode/charge injection layer/light-emitting layer/charge injection layer/cathode;
g) anode/charge injection layer/hole transport layer/light-emitting layer/cathode;
h) anode/hole transport layer/light-emitting layer/charge injection layer/cathode;
i) anode/charge injection layer/hole transport layer/light-emitting layer/charge injection layer/cathode;
j) anode/charge injection layer/light-emitting layer/charge transport layer/cathode;
k) anode/light-emitting layer/electron transport layer/charge injection layer/cathode;
l) anode/charge injection layer/light-emitting layer/electron transport layer/charge injection layer/cathode;
m) anode/charge injection layer/hole transport layer/light-emitting layer/charge transport layer/cathode;
n) anode/hole transport layer/light-emitting layer/electron transport layer/charge injection layer/cathode; and
o) anode/charge injection layer/hole transport layer/light-emitting layer/electron transport layer/charge injection layer/cathode;
(Symbol "/" indicates that the layers are stacked adjacent to each other. Hereinafter the same.)

In every example of the above-layered configurations, The metal oxide layer is provided as at least one layer of the charge injection layer, the hole transport layer, the electron transport layer and the charge injection layer.

Further, the organic EL element of the present invention may have two or more light-emitting layers.
Specifically, the organic EL element having the two light-emitting layers includes those having the layered configuration:
p) anode/charge injection layer/hole transport layer/light-emitting layer/electron transport layer/charge injection layer/electrode/charge injection layer/hole transport layer/light-emitting layer/electron transport layer/charge injection layer/cathode.
Specifically, the organic EL element having the three or more light-emitting layers includes those having the layered configuration containing two or more layers of repeating unit of electrode/charge injection layer/hole transport layer/light-emitting layer/electron transport layer/charge injection layer (hereinafter, referred to as repeating unit A):
q) anode/charge injection layer/hole transport layer/light-emitting layer/electron transport layer/charge injection layer/repeating unit A/repeating unit A..../cathode.
In the above layered configurations p) and q), the respective layers other than the anode, the cathode and the light-emitting layer may be omitted if necessary.
As used herein, the electrode is the layer that generates the hole and the electron by applying an electric field. Examples of materials that compose the electrode may include vanadium oxide, indium tin oxide and molybdenum oxide.
In each example of the above layered configurations p) and q), the metal oxide layer is provided as at least one layer of the charge injection layer, the hole transport layer and the electrode.

The organic EL element of the present invention may further have a substrate, and each layer may be provided on the substrate. The organic EL element of the present invention may further have a member for sealing on the opposite side to the substrate across the every layer. The organic EL element having the substrate and the above layered configuration ordinarily has the substrate on the side of the anode, but the present invention is not limited thereto. It may have the substrate on any side of the anode or the cathode.

In the organic EL element of the present invention, ordinarily, every layer on the one side from the light-emitting layer is transparent in order to emit the light from the light-emitting layer. Specifically, when the organic EL element has the configuration of substrate/anode/charge injection layer/hole transport layer/light-emitting layer/electron transport layer/charge injection layer/cathode/sealing member, for example, all of the substrate, the anode, the charge injection layer and the hole transport layer may be made transparent to make a so-called bottom emission type element, or alternatively all of the electron transport layer, the charge injection layer, the cathode and the sealing member may be made transparent to make a so-called top emission type element. Also when the organic EL element has the configuration of substrate/cathode/charge injection layer/electron transport layer/light-emitting layer/hole transport layer/charge injection layer/anode/sealing member, all of the substrate, the cathode, the charge injection layer and the electron transport layer may be made transparent to make the so-called bottom emission type element, or alternatively all of the hole transport layer, the charge injection layer, the anode and the sealing member may be made transparent to make the so-called top emission type element. As used herein, transparency is preferably 40% or more visible light transmittance from the light-emitting layer to the layer that emits the light. In the case of the element from which the light emitted in an ultraviolet region or an infrared region is required, it is preferable to have 40% or more transmittance in the corresponding region.

Further, the organic EL element of the present invention may be provided with the charge injection layer or an insulation layer having a film thickness of 2 nm or less adjacently to the electrode in order to enhance the adhesiveness to the electrode or improve the charge injection from the electrode. Also, a thin buffer layer may be inserted in an interface of the charge transport layer or the light-emitting layer in order to enhance the adhesiveness of the interface and prevent a blend. An order and the number of the layers to be stacked and the thickness of each layer can be appropriately determined by taking the light-emitting efficiency or an element lifetime into consideration.

Subsequently, the materials of each layer that constitutes the organic EL element of the present invention and the method for forming the layer will be described more specifically.

### <Substrate>

The substrate that constitutes the organic EL element of the present invention is not particularly limited as long as the substrate is not changed when the electrode is formed and the organic layer is formed, and usable examples may include a glass, a plastic, a polymer film, a silicon substrate and a laminate thereof. For the substrate, the commercially available substrate is obtainable and the substrate can be produced by a publicly known method.

### <Anode>

For the anode of the organic EL element of the present invention, it is preferable to use a transparent or translucent electrode because the element that emits the light through the anode may be configured. As such a transparent electrode or a translucent electrode, metal oxide, metal sulfide and a thin film of the metal having a high electric conductivity can be used, those having the high transmittance can be suitably utilized, and are appropriately selected and used depending on the organic layer to be used. Specifically, for example, films made using conductive glasses including indium oxide, zinc oxide, tin oxide, and indium tin oxide (ITO) and indium zinc oxide that are complexes thereof (NESA and the like), as well as gold, platinum, silver, copper and the like are used, and ITO, indium zinc oxide and tin oxide are preferable. The method for making the anode may include a vacuum deposition method, a sputtering method, an ion plating method and a plating method. Organic transparent conductive films of polyaniline or the derivative thereof or polythiophene or the derivative thereof may also be used as the anode.
For the anode, materials that reflect the light may be used. As the materials, metals, metal oxide and metal sulfide having a work function of 3.0 eV or more are preferable.

The film thickness of the anode can be appropriately selected in consideration of light transmission and the electric conductivity, and is for example 10 nm to 10 µm, preferably 20 nm to 1 µm and more preferably 50 nm to 500 nm.

### <Hole injection layer>

The hole injection layer may be provided between the anode and the hole transport layer or between the anode and the light-emitting layer. In preferable aspects of the present invention, the metal oxide layer may be used as the hole injection layer.
When the organic EL element of the present invention has the metal oxide layer as the layer other than the hole injection layer, examples of the material that forms the hole injection layer may include phenylamine-based compounds, starburst type amine-based compounds, phthalocyanine-based compounds, oxides such as vanadium oxide, tantalum oxide, tungsten oxide, molybdenum oxide, ruthenium oxide and aluminium oxide, amorphous carbon, polyaniline and polythiophene derivatives.

### <Hole transport layer>

The metal oxide layer may be used as the hole transport layer in some cases, but in the cases other than that case, usable examples of the material that composes the hole transport layer may include polyvinylcarbazole or derivatives thereof, polysilane or derivatives thereof, polysiloxane derivatives having aromatic amine in a side chain or a main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrol or derivatives thereof, poly(p-phenylene vinylene) or derivatives thereof, and poly(2,5-thienylene vinylene) or derivatives thereof.

Among them, as the hole transport materials used for the hole transport layer, preferable are polymeric hole transport materials such as polyvinylcarbazole or the derivatives thereof, polysilane or the derivatives thereof, the polysiloxane derivatives having aromatic amine in the side chain or the main chain, polyaniline or the derivatives thereof, polythiophene or the derivatives thereof, polyarylamine or the derivatives thereof, poly(p-phenylene vinylene) or derivatives thereof or poly(2,5-thienylene vinylene) or the derivatives thereof, and more preferable are polyvinylcarbazole or the derivatives thereof, polysilane or the derivatives thereof and the polysiloxane derivatives having aromatic amine in the side chain or the main chain are more preferable. When the hole transport material is a small molecule, it is preferable to use by being dispersed in a polymeric binder.

The method for forming a film of the hole transport layer is not limited, and an example when using a small molecule hole transport material is a method for forming a film from a mixed solution with the polymeric binder. An example when using a high molecular hole transport material is a method for forming the film from a solution.

The solvent used for forming the film from the solution is not particularly limited as long as the hole transport material is dissolved therein. Examples of solvents may include chlorine-based solvents such as chloroform, methylene chloride and dichloroethane, ether-based solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate are exemplified.

Usable examples of the method for forming the film from the solution may include coating methods such as the spin coating method, the casting method, the microgravure coating method, the gravure coating method, the bar coating method, the roll coating method, the wire bar coating method, the dip coating method, the slit coating method, the capillary coating method, the spray coating method and the nozzle coating method; and printing methods such as the gravure printing method, the screen printing method, the flexographic printing method, the offset printing method, the reverse printing method and the inkjet printing method. The printing methods such as the gravure printing method, the screen printing method, the flexographic printing method, the offset printing method, the reverse printing method and the inkjet printing method are preferable because patterning is easy.

As the polymeric binder to be mixed, those that do not inhibit the charge transport excessively are preferable, and those that do not absorb the visible light strongly are suitably used. Examples of the polymeric binder may include polycarbonate, polyacrylate, polymethyl acrylate, polymethyl methacrylate, polystyrene, polyvinyl chloride and polysiloxane.

An optimal film thickness of the hole transport layer varies depending on the material to be used, and may be selected so that a driving voltage and the light-emitting efficiency have reasonable value. However, the thickness such that at least no pinhole occurs is necessary, and the excessively thick thickness is not preferable because the driving voltage of the element becomes high. Therefore, the film thickness of the hole transport layer is, for example, 1 nm to 1 µm, preferably 2 nm to 500 nm and more preferably 5 to 200 nm.

### <Light-emitting layer>

The light-emitting layer is preferably an organic light-emitting layer in the present invention, and ordinarily has the organic matter (small compounds and large compounds) that emits mainly fluorescence or phosphorescence. The light-emitting layer may further contain a dopant material. Usable examples of the material that forms the light-emitting layer in the present invention may include the following light-emitting materials.

### Dye materials

Examples of dye materials may include cyclopendamine or derivatives thereof, tetraphenylbutadiene or derivatives thereof, triphenylamine or derivatives thereof, oxadiazole or derivatives thereof, pyrazoloquinoline or derivatives thereof, distylylbenzene or derivatives thereof, distylylarylene or derivatives thereof, pyrrol or derivatives thereof, thiophene ring compounds, pyridine ring compounds, perinone or derivatives thereof, perylene or derivatives thereof, oligothiophene or derivatives thereof, trifumanylamine or derivatives thereof, oxadiazole dimers, pyrazoline dimers, quinacridone or derivatives thereof, coumarin or derivatives thereof, rubrene or derivatives thereof, squarium or derivatives thereof, porphyrin or derivatives thereof, stylyl-based dye, tetracene or derivatives thereof, pyrazolone or derivatives thereof, decacyclene and phenoxazone.

### Metal complex materials

Examples of metal complex materials may include metal complexes having the light emitted from a triplet excited state, such as iridium complexes and platinum complexes; and aluminum quinolinol complex, beryllium benzoquinolinol complex, zinc benzoxazolyl complex, zinc benzothiazole complex, zinc azomethyl complex, zinc porphyrin complex and europium complex, and other metal complexes having Al, Zn, Be, or a rare earth metal such as Tb, Eu or Dy in a central metal and having an oxadiazole, thiadiazole, phenylpyridine, phenylbenzimidazole or quinoline structure as a ligand.

### Polymer materials

Examples of polymer-based materials may include polyparaphenylene vinylene or derivatives thereof, polythiophene or derivatives thereof, polyparaphenylene or derivatives thereof, polysilane or derivatives thereof, polyacetylene or derivatives thereof, polyfluorene or derivatives thereof, polyvinylcarbazole or derivatives thereof, and polymerized products of the aforementioned dye materials and the aforementioned metal complex-based materials.
Among the above light-emitting materials, the materials that emit blue light may include distylylarylene derivatives, oxadiazole derivatives and polymers thereof, polyvinylcarbazole derivatives, polyparaphenylene derivatives and polyfluorene derivatives. Among them, preferable are the polyvinylcarbazole derivatives, the polyparaphenylene derivatives and the polyfluorene derivatives that are the polymer materials.
The materials that emit green light may include quinacridone derivatives, coumarin derivatives and polymers thereof, polyparaphenylene vinylene derivatives and polyfluorene derivatives. Among them, preferable are the polyparaphenylene vinylene derivatives and the polyfluorene derivatives that are the polymer materials.
The materials that emit red light may include coumarin derivatives, thiophene ring compounds and polymers thereof, polyparaphenylene vinylene derivatives, polythiophene derivatives and polyfluorene derivatives. Among them, preferable are the polyparaphenylene vinylene derivatives, the polythiophene derivatives and polyfluorene derivatives that are the polymer materials.

### Dopant materials

A dopant may be added in the light-emitting layer for the purpose of enhancing the light-emitting efficiency and changing the wavelength of the light to be emitted. Examples of such dopants may include perylene derivatives, coumarin derivatives, rubrene derivatives, quinacridone derivatives, squarium derivatives, porphyrin derivatives, styryl-based dye, tetracene derivatives, pyrazolone derivatives, decacyclene and phenoxazone. The thickness of such a light-emitting layer is ordinarily about 2 to 200 nm.

### <Method for forming film of light-emitting layer>

As the method for forming the film of the light-emitting layer containing an organic matter, it is possible to use a method of applying the solution containing the light-emitting material on a base or upward thereof, the vacuum deposition method or a transfer method. Specific examples of the solvent used for forming the film from the solution may include solvents similar to the solvents in which the hole transport material is dissolved when the film of the hole transport material is formed from the aforementioned solution.
Usable examples of the method of applying the solution containing the light-emitting material on the base or upward thereof may include coating methods such as the spin coating method, the casting method, the microgravure coating method, the gravure coating method, the bar coating method, the roll coating method, the wire bar coating method, the dip coating method, the slit coating method, the capillary coating method, the spray coating method and the nozzle coating method; and printing methods such as the gravure printing method, the screen printing method, the flexographic printing method, the offset printing method, the reverse printing method and the inkjet printing method. The printing methods such as the gravure printing method, the screen printing method, the flexographic printing method, the offset printing method, the reverse printing method and the inkjet printing method are preferable because the patterning and color coding of multiple colors are easy. When a sublimatic small compound is used, the vacuum deposition method can be used. Further, the method for forming the light-emitting layer only on a desired section by laser transfer or heat transfer can also be used.

### <Electron transport layer>

The metal oxide layer may be used as the electron transport layer in some cases, but in the cases other than that case, those publicly known may be used as the material that constitutes the electron transport layer, and examples may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof and polyfluorene or derivatives thereof.

Among them, preferable are the oxadiazole derivatives, benzoquinone or the derivatives thereof, anthraquinone or the derivatives thereof, or the metal complexes of 8-hydroxyquinoline or the derivatives thereof, polyquinoline or the derivatives thereof, polyquinoxaline or the derivatives thereof and polyfluorene or the derivatives thereof, and more preferable are 2-(4-biphenylyl)-5-(4-t-butylphenyl)-1,3,4-oxadiazole, benzoquinone, anthraquinone, tris(8-quinolinol)aluminium and polyquinoline.

The method for forming the film of the electron transport layer is not particularly limited. The vacuum deposition method from powder or the method for forming the film from the solution or a melted state is exemplified for small molecular electron transport materials, and the method for forming the film from the solution or the melted state is exemplified for large molecular electron transport materials. When the film is formed from the solution or the melted state, the polymeric binder may be used simultaneously. The method for forming the film of the electron transport layer from the solution may include methods for forming the film, which are similar to the method for forming the film of the hole transport layer from the aforementioned solution.

The optimal film thickness of the electron transport layer varies depending on the material to be used, and may be selected so that the driving voltage and the light-emitting efficiency have reasonable value. However, the thickness such that at least no pinhole occurs is necessary, and the excessively thick thickness is not preferable because the driving voltage of the element becomes high. Therefore, the film thickness of the electron transport layer is, for example, 1 nm to 1 µm, preferably 2 nm to 500 nm and more preferably 5 to 200 nm.

### <Electron injection layer>

The electron injection layer is provided between the electron transport layer and the cathode or between the light-emitting layer and the cathode. The metal oxide layer may be used as the electron injection layer in some cases, but in the cases other than that case, materials of the electron injection layer may include alkali metals and alkali earth metals, alloys containing one or more of the above metals, or oxide, halide and carbonate of the above metals, or mixtures thereof depending on the type of the light-emitting layer. Examples of the alkali metals, oxide, halide and carbonate thereof may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride and lithium carbonate. Examples of the alkali earth metals, oxide, halide and carbonate thereof may include magnesium, calcium, barium, strontium, magnesium oxide, magnesium fluoride, calcium oxide, calcium fluoride, barium oxide, barium fluoride, strontium oxide, strontium fluoride and magnesium carbonate. Two or more electron injection layers may be stacked. Specific examples may include LiF/Ca. The electron injection layer is formed by the deposition method, the sputtering method or the printing method. The film thickness of the electron injection layer is preferably about 1 nm to 1 µm.

### <Cathode materials>

As the material of the cathode used in the organic EL element of the present invention, the materials which have the small work function and by which the electron is easily injected in the light-emitting layer, and/or the materials having the high electric conductivity, and/or the materials having a high visible light reflectance are preferable. As the metal, the alkali metals, the alkali earth metals, transition metals and metals in III-B Group may be used. Usable examples may include metals such as lithium, sodium, potassium, rubidium, cesium, beryllium, magnesium, calcium, strontium, barium, aluminium, scandium, vanadium, zinc, yttrium, indium, cerium, samarium, europium, terbium and ytterbium; alloys of two or more of the above metals; alloys of one or more of the above metals and alloys with one or more of gold, silver, platinum, copper, manganese, titanium, cobalt, nickel, tungsten and tin; and graphite or graphite interlayer compounds. Examples of the alloy may include magnesium-silver alloys, magnesium-indium alloys, magnesium-aluminium alloys, indium-silver alloys, lithium-aluminium alloys, lithium-magnesium alloys, lithium-indium alloys and calcium-aluminium alloys. A transparent conductive electrode may be used as the cathode, and for example, conductive metal oxide, conductive organic matters or the like can be used. Specifically, as the conductive metal oxide, indium oxide, zinc oxide, tin oxide, and indium tin oxide (ITO) and indium zinc oxide (IZO) which are the complexes thereof may be used, and as the conductive organic matters, organic transparent conductive films of polyaniline or derivatives thereof, polythiophene or derivatives thereof and the like may be used. The stacked structure of two or more layers may be used as the cathode. The electron injection layer may be used as the cathode in some cases.

The film thickness of the cathode may be appropriately selected in consideration of the electric conductivity and durability, and is, for example, 10 nm to 10 µm, preferably 20 nm to 1 µm and more preferably 50 nm to 500 nm.

As the method for making the cathode, the vacuum deposition method, the sputtering method or a laminate method in which a metal thin film is bonded with pressure may be used.

### <Insulation layer>

An insulation layer having the film thickness of 2 nm or less, which may be optionally possessed by the organic EL element of the present invention, has the function of making the electron injection easy. The material for the insulation layer may include metal fluoride, metal oxide and organic insulation materials. The organic EL element provided with the insulation layer having the film thickness of 2 nm or less may include those provided with the insulation layer having the film thickness of 2 nm or less adjacent to the cathode and those provided with the insulation layer having the film thickness of 2 nm or less adjacent to the anode.

The organic EL element of the present invention may be used as planar light sources and as backlights for segment display devices, dot matrix display devices and liquid crystal display devices.

To obtain a planar emitted light using the organic EL element of the present invention, a planar anode and a planar cathode may be disposed to be superimposed each other. To obtain a patterned emitted light, the method of placing a mask provided with a patterned window on the surface of the planar light-emitting element, the method for forming an excessively thick organic layer in a non-light-emitting section to make substantial non-light-emitting, and the method for patterning a electrode or electrodes in either the anode or the cathode or both of the electrodes are available. A segment type of a display element that can display numeric characters, letters, simple signs and the like is obtained by patterning by any of these methods and disposing some electrodes so as to independently turn on and off the electrodes. Further, to make a dot matrix element, both the anode and the cathode may be formed into a stripe-shape and disposed orthogonally. A partial color display and a multicolor display become possible by color-coding of multiple types of the light-emitting materials that emit the different colored light or by using color filters or fluorescence conversion filters. The dot matrix element can be passively driven, and may be actively driven by combining with TFT. These display elements can be used as the display devices for computers, televisions, mobile terminals, mobile phones, car navigations, view finders of video cameras and the like.

In addition, the planar light-emitting element is a self-light-emitting thin type, and can be used suitably as the planar light source for the backlight for the liquid crystal display device or the planar light source for illuminating. If a flexible substrate is used, the light-emitting element can be used for the light sources and the display device having a curved surface.

### EXAMPLES

The present invention will be described in more detail below with reference to Examples and Comparative Examples, but the present invention is not limited thereto.

### <Example 1>

### (1-1: Preparation of coating solution)

MoO₃ powder (manufactured by Aldrich, purity: 99.99%) in an amount equal to or more than a saturated amount at 23°C was added in ultrapure water (specific resistance value: 18 MΩ·cm or more), and a precipitate was removed, thus obtaining a coating solution.

### (1-2: Preparation of electron block layer material)

In a separable flask equipped with a stirring blade, a baffle, a nitrogen introducing tube whose length was adjustable, a cooling tube and a thermometer, 158.29 parts by weight of 2,7-bis(1,3,2-dioxaborolane-2-yl)-9,9-dioctylfluorene, 136.11 parts by weight of bis(4-bromophenyl)-4-(1-methylpropyl)-benzeneamine, 27 parts by weight of tricaprylmethylammonium chloride (Aliquat 336, manufactured by Henkel) and 1800 parts by weight of toluene were placed, and a temperature was raised to 90°C under stirring with running nitrogen from the nitrogen introducing tube. After adding 0.066 part by weight of palladium (II) acetate and 0.45 part by weight of tri(o-toluyl)phosphine, 573 parts by weight of an aqueous solution of 17.5% sodium carbonate was dropped over one hour. After completion of the dropping, the nitrogen introducing tube was pulled up from a solution surface, the solution was kept warm under reflux for 7 hours. Then, 3.6 parts by weight of phenylboric acid was added, the temperature was kept warm under the reflux for 14 hours, and then cooled to room temperature. The aqueous layer was removed from the reaction solution. Subsequently, the oil layer of the reaction solution was diluted with toluene, and washed with an aqueous solution of 3% acetic acid and ion-exchange water. To the separated oil layer, 13 parts by weight of sodium N,N-diethyldithiocarbamate trihydrate was added to the separated oil layer, and the mixture was stirred for 4 hours. Then, the mixture was applied to a mixed column of active alumina and silica gel, and toluene was passed through the column to wash the column. The filtrate and the washed solution were mixed, and dropped into methanol to precipitate a polymer. The resulting precipitate of the polymer was filtered off, and the precipitate was washed with methanol. Subsequently, the polymer was dried by a vacuum dryer, thus obtaining 192 parts by weight of the polymer. The obtained polymer is referred to as a polymer compound 1. A weight-average molecular weight and a number-average molecular weight in terms of polystyrene were determined for the polymer compound 1 by the following GPC analysis method, and its weight-average molecular weight and number-average molecular weight in terms of polystyrene were 3.7×10⁵ and 8.9×10⁴, respectively.

### (GPC analysis method)

The weight-average molecular weight and the number-average molecular weight in terms of polystyrene were determined by gel permeation chromatography (GPC). Standard polystyrene manufactured by Polymer Laboratories Inc. was used to prepare a standard curve for GPC. The polymer to be measured was dissolved in tetrahydrofuran at a concentration of about 0.02% by weight, and 10 µL thereof was injected in a GPC apparatus.
LC-10ADvp manufactured by Shimadzu Corporation was used as the GPC apparatus. Two tandemly connected PLgel 10 µm MIXED-B columns (300x7.5 mm) manufactured by Polymer Laboratories Inc. were used as the column, and tetrahydrofuran was flowed at a flow rate of 1.0 mL/min at 25°C as a mobile phase. A UV detector was used as a detector, and absorbance at 228 nm was measured.

### (1-3: Manufacture of organic EL element: MoO₃ layer)

A glass substrate on the surface of which a thin film of ITO had been patterned was used as the substrate, and the coating solution obtained in above (1-1) was applied on this thin film of ITO by a spin coating method. A rotation frequency of the substrate was 500 rpm and a period of time for the application was 30 seconds. The coated film was naturally dried, and then the coated film in an extraction electrode section and a sealing area was wiped and removed with a cotton swab impregnated with pure water or acetone. Then the coated film was treated with heat using a hotplate at 120°C for 10 minutes in atmospheric air and then cooled to room temperature to obtain a cured MoO₃ layer. An appearance of the obtained layer was visually observed and evaluated, and the layer had the uniform film quality equal to that in Comparative Example 1 described later.

### (1-4: Manufacture of organic EL element: making of other layers and sealing)

Then, a film of the electron block layer material obtained in above (1-2) was formed on the obtained MoO₃ layer by the spin coating method to form an electron block layer having the film thickness of 20 nm. The film of the electron block layer formed in the extraction electrode section and the sealing area was removed, and then baked on the hotplate at 200°C for 20 minutes.
Subsequently, a film of a large molecule light-emitting organic material (RP158 manufactured by Sumation) was formed on the electron block layer by the spin coating method to form a light-emitting layer having the film thickness of 90 nm. The film of the light-emitting layer formed in the extraction electrode section and the sealing area was removed.
A subsequent process to the sealing was conducted in vacuum or in nitrogen not to expose the element during the process to the atmospheric air.
The substrate was heated at 100°C for 60 minutes in a heating room in vacuum. Subsequently, the substrate was transferred into a deposition chamber and a cathode mask was aligned on the surface of the light-emitting layer so that a film of the cathode was formed on the light-emitting section and the extraction electrode section. The cathode was deposited as the mask and the substrate were rotated. As the cathode, the metal Ba was heated by a resistance heating method and deposited at a deposition rate of about 0.2 nm/second so as to have the film thickness of 5 nm, and Al was deposited thereon at a deposition rate of 0.2 nm/second using an electron beam deposition method so as to have the film thickness of 150 nm.
Subsequently, the substrate was bonded to a previously prepared sealing glass around which a UV curable resin had been applied, they were kept in vacuum, then returned in the atmospheric air and irradiated with UV to fix, thus manufacturing an organic EL element having a light-emitting region of 2x2 mm. The resulting organic EL element has a layered configuration of glass substrate/ITO film/MoO₃ layer/electron block layer/light-emitting layer/Ba layer/Al layer/sealing glass.

### (1-5: Evaluation of organic EL element)

An electric current was applied to the manufactured element, and a voltage at which a level of the light emitting was 10 cd/m² was recorded as a light emission starting voltage. The electric current was applied so that a luminance was 2000 cd/m², and a maximum value of a light-emitting efficiency and a half-life of the luminance were measured. Results are shown in Table 1. It was observed that the light-emitting efficiency was much higher and the light emission starting voltage was lower compared with Comparative Example 1 described later.

### <Example 2>

In the formation of the film of the MoO₃ layer, a cured MoO₃ layer was obtained in the same manner as in Example 1 (1-1) to (1-3), except that a cast method (0.5 of the coating solution was sucked into a syringe and applied by flow casting on the light-emitting region) was employed in place of the spin coating method. The resulting layer was visually observed and its appearance was evaluated, and the layer had the uniform film quality equal to that in Comparative Example 1 described later.

Further, an organic EL element was manufactured and evaluated in the same manner as in Example 1 (1-4) and (1-5). The results are shown in Table 1. It was observed that the light-emitting efficiency was higher, the light emission starting voltage was lower and the lifetime is very long compared with Comparative Example 1 described later.

### <Comparative Example 1>

### (Deposition of MoO₃ onto glass substrate by vacuum deposition method)

The same glass substrate as one used in Example 1 on the surface of which the ITO thin film had been patterned was used as the substrate. An MoO₃ layer having the film thickness of 10 nm was deposited on this ITO thin film by the vacuum deposition method using the following procedure.
The surface on the side having the ITO thin film of the glass substrate was partially covered using a deposition mask, and a substrate holder was attached in the deposition chamber.
The MoO₃ powder (manufactured by Aldrich, purity: 99.99%) was filled in a box type of a tungsten board for the sublimatic substance, which was covered with a cover having holes so that the material did not scatter, and then set in the deposition chamber.
The vacuum degree in the deposition chamber was 3×10⁻⁵ Pa or less, and the MoO₃ powder was gradually heated by the resistance heating method to thoroughly perform degassing, and then subjected to the deposition. The vacuum degree during the deposition was 9×10⁻⁵ Pa or less. The film thickness and the deposition rate were constantly monitored using a quartz oscillator. When the deposition rate of MoO₃ became about 0.28 nm/second, a main shutter was opened and the formation of the film on the substrate was started. The substrate was rotated during the deposition so that the film thickness became uniform. The deposition rate was controlled to the above rate, and the formation of the film was performed for about 36 seconds to obtain the substrate on which the deposited film having the film thickness of about 10 nm had been provided. The resulting layer was visually observed and its appearance was evaluated, and the layer had the uniform film quality.

The resulting substrate was further manipulated in the same manner as in Example 1 (1-4) and (1-5) to manufacture and evaluate an organic EL element. The results are shown in Table 1.

[TABLE 1]

**TABLE 1.**

| | Light-emitting efficiency | Light emission starting voltage | A half-life of luminance |
|---|---|---|---|
| | (1 m/W) | (V; at 10 cd/m²) | (hr; at 2000 cd/m²) |
| Example 1 | 1.14 | 3.56 | 194 |
| Example 2 | 0.54 | 3.98 | 242 |
| Comparative Example 1 | 0.52 | 4.30 | 209 |

## Claims

1. An organic electroluminescence element comprising an anode, a light-emitting layer, a cathode, and a metal oxide layer provided between said anode and said light-emitting layer or between the light-emitting layer and the cathode,
wherein the metal oxide layer is a layer formed by applying a solution containing metal oxide and a solvent on another layer that constitutes the element.

2. The organic electroluminescence element according to claim 1, wherein the metal oxide layer is a hole injection layer, or is provided in direct contact with the light-emitting layer or the hole injection layer.

3. The organic electroluminescence element according to claim 1, wherein a visible light transmittance of the metal oxide layer is 50% or more.

4. The organic electroluminescence element according to claim 1, wherein the metal oxide is selected from the group consisting of molybdenum oxide, vanadium oxide, tungsten oxide and mixtures thereof.

5. A method for manufacturing the organic electroluminescence element according to claim 1, comprising a step of applying the solution on the another layer that constitutes the element.

6. The manufacturing method according to claim 5, wherein the applying is performed by a spin coating method, a cast method, a capillary coating method or a printing method.

7. A coating solution comprising metal oxide and a solvent, being used for making a metal oxide layer in the organic electroluminescence element according to claim 1.
